# EUROPEAN PATENT SPECIFICATION

(11) **EP 3 792 374 B1**
(45) Date of publication and mention of the grant of the patent: **09.11.2022**
(21) Application number: 20816874.0
(22) Date of filing: 13.02.2020
(51) Int. Cl.: C23C 18/40, H05K 3/18, H05K 1/03

(54) **ELECTROLESS COPPER PLATING BATH**
BAD FÜR STROMLOSE KUPFERPLATTIERUNG
BAIN DE CUIVRAGE AUTOCATALYTIQUE

(30) Priority: 17.07.2019 JP 2019132151
(43) Date of publication of application: 17.03.2021
(73) Proprietor: C. Uyemura & Co., Ltd., Osaka-shi, Osaka 541-0045 (JP)
(72) Inventor: TAKADA, Hideaki, Hirakata-shi Osaka 5730065 (JP); NAKAYAMA, Tomoharu, Hirakata-shi Osaka 5730065 (JP); YAMAMOTO, Hisamitsu, Hirakata-shi Osaka 5730065 (JP); ODA,Yukinori, Hirakata-shi Osaka 5730065 (JP)
(74) Representative: Germain Maureau
(86) International application number: PCT/JP2020/005561
(87) International publication number: WO 2021/009951

(56) References cited:
- CN-A- 104 313 553
- CN-A- 106 148 923
- CN-A- 108 468 039
- CN-B- 106 148 923
- FR-E- 88 424
- JP-A- H0 474 870
- JP-A- S6 320 486
- JP-A- H01 242 781
- JP-A- H03 287 780
- JP-A- H06 306 622
- JP-A- H07 197 266
- JP-A- H07 197 266
- KRONENBERG W: "STAND DER AUSSENSTROMLOSEN FORMALDEHYDFREIEN KUPFERABSCHEIDUNG", GALVANOTECHNIK, LEUZE VERLAG, vol. 81, no. 4, 1 April 1990 (1990-04-01), pages 1235-1239, XP000137938, ISSN: 0016-4232

## Description

### TECHNICAL FIELD

The present invention relates to an electroless copper plating bath that does not contain formaldehyde and can be used in a neutral condition.

### BACKGROUND ART

Conventional electroless copper plating baths contain formaldehyde as a reducing agent for copper ions; formaldehyde has high vapor pressure, and the worsening of work environments by irritating odor and an adverse effect on human bodies due to carcinogenicity have been pointed out. Electroless copper plating baths containing formaldehyde are strongly alkaline, are thus likely to cause degradation of objects to be plated, and their usages have been limited.

Given these circumstances, electroless copper plating baths containing a reducing agent other than formaldehyde have been developed. Specifically, an electroless copper plating bath containing hypophosphite as a reducing agent has been developed, for example. This hypophosphite does not have any catalytic function on copper and is thus added to a plating bath containing intermediating metal ions, or a metal salt of nickel, cobalt, or the like, for example (refer to Non-Patent Document 1, for example).

### CITATION LIST

### NON-PATENT DOCUMENT

Non-Patent Document 1: [Surface Technology]Vol. 48, No. 4, 1997

CN108468039 discloses a chemical copper plating liquid to be applied to a zinc oxide pressure sensitive resistor copper electrode, said liquid comprising copper sulfate, EDTA and/or EDTA disodium, tetrahydroxypropyl ethylenediamine, disodium edetate dihydrate, sodium hydroxide, sodium monophosphate, hydrazine hydrate, 2,2'-bipyridyl, a surface active agent, an accelerator and an antioxidant.

CN104313553A discloses an electroless copper plating liquid which comprises 10-20 g/L of a copper salt, 1-3 g/L of a stabilizer 5-methyl-4-(6-methoxy-2-naphthyl)-2-(2-benzylimino)thiazole, 0.5-1.5 g/L of a stabilizer that is ((1-dimethylamino)-alkyl phosphoric acid)-N-allyloleamide-acrylic acid-acrylamide copolymer, 30-50 g/L of a disodium ethylenediaminetetraacetate dihydrate complexing agent, 10-20 g/L of alcohol amine, 3-5 g/L of a Gemini type quaternary ammonium salt, 5-8 g/L of potassium sodium tartrate, 0.5-1.5 g/L of sodium dodecylbenzenesulfonate, 4-10 g/L of sodium hypophosphite, 2-4 g/L of hydrazine hydrate, 0.5-1.5 g/L of an accelerator and 0.05-0.2 g/L of bis-(sodium sulfopropyl)-disulfide.

CN106148923B discloses a chemical copper plating solution which is an aqueous solution of copper sulfate, magnesium stearate, sodium ethylene diamine tetracetate, alkylol amine, sodium dodecyl benzene sulfonate, sodium hypophosphite, hydrazine hydrate, boracic acid, sodium 3,3'-dithiodipropane sulfonate, lecithin and starch acetate, said solution being used for treating a tire bead steel wire of a radial tire.

JPH07197266A discloses a direct plating method for producing metallic copper on the surface of a non-conducting substrate catalyzed by a copper catalyst containing a copper (I) oxide colloid implementing an electroless copper plating bath which may comprise copper chloride, ethylenediamine tetraacetic acid disodium, glycin, dimethylamine borane and sulfuric acid.

FR88424E discloses copper plating solutions which may comprise hydrazine sulfate and N-hydroxyethyl ethylene diamine triacetate.

W. Kronenberg, "Stand der Aussenstromlosen Formaldehydfreien Kupferabscheidung" Galvanotechnik, Leuze Verlag, vol. 81, no. 4, 1990, pages 1235-1239 also discloses an electroless copper plating bath that may include N-hydroxyethyl ethylene diamine triacetate.

### SUMMARY OF THE DISCLOSURE

### TECHNICAL PROBLEM

Hypophosphite does not have any catalytic activity on copper. Thus, in the conventional electroless copper plating bath containing hypophosphite, it is common to add nickel, which is metal showing catalytic activity to hypophosphite. However, this nickel is metal inferior to copper in conductivity, and nickel is codeposited with a copper deposit from this plating bath, resulting in a problem in that conductivity is insufficient in many electronic circuit uses.

Widely known is a method that causes metallic catalytic particles such as palladium or the like as a catalyst for forming a plated layer to be replaced with base metal and forms a plated layer by electroless plating with the catalyst serving as the starting point of a plating reaction. However, when the metallic catalytic particles such as palladium or the like replace a copper base, metallic particles of palladium or the like are present at an interface between the base copper and electroless copper plating, resulting in a problem in that resistivity increases in a fine wiring circuit in particular. Consequently, conductivity is insufficient.

In view of the problem described above, it is therefore an object of the present invention to provide an electroless copper plating bath that does not contain formaldehyde and enables deposition on copper without imparting any catalyst in a neutral condition in which degradation of an object to be plated hardly occurs.

### SOLUTION TO THE PROBLEM

To achieve the above object, an electroless copper plating bath of the present invention is an electroless copper plating bath with a pH of 5 to 10 containing a hydrazine compound as a reducing agent and not containing formaldehyde, the electroless copper plating bath comprises at least: an amine-based complexing agent or an amine compound; an aminocarboxylic acid-based complexing agent and a carboxylic acid-based complexing agent, as defined in claim 1.

### ADVANTAGES OF THE INVENTION

The present invention can provide an electroless copper plating bath that does not contain formaldehyde and has excellent deposition properties and bath stability and enables deposition on copper without imparting any catalyst in a neutral condition.

### DESCRIPTION OF EMBODIMENTS

Hereinafter, an electroless copper plating bath of the present invention will be described.

### <Electroless Copper Plating Bath>

The electroless copper plating bath of the present invention is a plating bath containing a hydrazine compound as a reducing agent, an amine-based complexing agent, and an aminocarboxylic acid-based complexing agent. The electroless copper plating bath of the present invention can be prepared with a bath composition not containing any alkali metal salt such as sodium, potassium, or the like and can suitably be used in the manufacture of semiconductor wafers.

### (Reducing Agent)

The electroless copper plating bath of the present invention contains the hydrazine compound in place of the conventional formaldehyde as the reducing agent. Examples of this hydrazine compound include hydrazine monohydrate, hydrazinium chloride, hydrazinium sulfate, dimethyl hydrazine, acetohydrazide, and carbohydrazide.

The concentration of the reducing agent in the plating bath is preferably 0.1 to 1.0 M and more preferably 0.2 to 0.5 M.

### (pH)

As described above, the electroless copper plating bath of the present invention contains the hydrazine compound, which can be used in weakly acidic to alkaline conditions, as the reducing agent. Thus, the pH of the plating bath of the present invention is 5 or more, preferably 5 to 10, and more preferably 6 to 8. With a pH of 5 or more, plating treatment can be performed without damaging a base as an object to be plated.

The pH of the plating bath can be adjusted by a pH adjuster such as sodium hydroxide, potassium hydroxide, ammonia water, tetramethyl ammonium hydroxide, sulfuric acid, hydrochloric acid, boric acid, phosphoric acid, monocarboxylic acid, or dicarboxylic acid.

### (Amine-Based Complexing Agent)

When the hydrazine compound described above is used as the reducing agent in a neutral condition (pH 5 to 10), the difference in oxidation-reduction potential between complexed copper ions and the hydrazine compound, that is, the driving force of a plating reaction (reducing power) is weaker than a case of an alkaline condition (pH > 10). Thus, the plating reaction hardly progresses.

Given these circumstances, in the present invention, an amine-based complexing agent is used in view of reducing the risk of decrease in the reducing power of the hydrazine compound in the neutral condition to improve deposition properties and bath stability.

This amine-based complexing agent is selected from the group consisting of a diamine compound, a triamine compound, and an aromatic amine compound. Examples of the diamine compound include ethylene diamine, trimethylenediamine, and propylenediamine. Examples of the triamine compound include diethylenetriamine, dipropylenetriamine, and ethylenepropylenetriamine. Examples of the aromatic amine compound include 2-(aminomethyl)pyridine, 2-amino pyridine, 2,6-pyridine dicarboxylic acid, and o-phenylenediamine.

In general, when a complexing agent having strong complexing power to copper is used, a complex with copper ions is stabilized, and in the neutral condition (pH 5 to 10), the driving force of the plating reaction is insufficient, and thus the reaction does not proceed. However, in the alkaline condition (pH > 10), to hold bath stability, the complexing agent having strong complexing power such as ethylene diamine tetraacetic acid or diethylene triamine pentaacetic acid is required to be used. It is considered that these complexing agents have a large value of a stability constant, which is an indicator of complexing power, and are thus likely to form the complex with copper and have a large coordination number. Hence, these complexing agents seem to have strong complexing power.

On the other hand, when a complexing agent having weak complexing power to copper is used, complex formation with copper ions is hard to be held not only in the alkaline condition (pH > 10) but also in the neutral condition (pH 5 to 10). Hence, bath decomposition is likely to be caused.

Given these circumstances, the electroless copper plating bath of the present invention contains the diamine compound, the triamine compound, or the aromatic amine compound described above as the amine-based complexing agent to stabilize the complex with copper. In addition, these compounds have a smaller stability constant than that of ethylene diamine tetraacetic acid or diethylene triamine pentaacetic acid, have a coordination number of two to three, and can thus control the balance between plating deposition properties and bath stability.

The concentration of the amine-based complexing agent in the plating bath is preferably 0.01 to 1.0 M and more preferably 0.1 to 0.6 M.

### (Aminocarboxylic Acid-Based Complexing Agent)

When a plating reaction is performed on a copper surface, the reaction does not proceed unless copper as a base is in a clean state (that is, a state in which the surface copper is not oxidized).

Given these circumstances, in the present invention, an aminocarboxylic acid-based complexing agent is used in view of etching copper oxide on the copper surface to facilitate deposition on copper. This aminocarboxylic acid-based complexing agent makes it possible to easily remove a film of oxide on the copper surface and hold the copper surface at the clean state.

According to the invention, the aminocarboxylic acid-based complexing agent is chosen from nitrilotriacetic acid, diethylene triamine pentaacetic acid, triethylene tetramine hexaacetic acid, 1,3-propane diamine tetraacetic acid, 1,3-diamino-2-hydroxypropane tetraacetic acid, hydroxyethylimino diacetic acid, dihydroxyethyl glycine, glycol ether diamino tetraacetic acid, dicarboxymethyl glutamic acid and ethylenediamine-N,N'-disuccinic acid.

The concentration of the aminocarboxylic acid-based complexing agent in the plating bath is preferably 0.01 to 1.0 M and more preferably 0.05 to 0.4 M.

Among aminocarboxylic acids, when the amount of diethylene triamine pentaacetic acid added, which has a high stability constant for copper, is large, the driving force of the plating reaction is insufficient to make the reaction hardly progress, as described above. Thus, in one preferred embodiment, the amount is small.

In one preferred embodiment, the electroless copper plating bath of the present invention mainly contains the amine-based complexing agent described above having more complexing power and a more excellent bath stability improvement effect than the aminocarboxylic acid-based complexing agent. the electroless copper plating bath further contains the aminocarboxylic acid-based complexing agent as a second complexing agent having an auxiliary function for the amine-based complexing agent.

### (Amine Compound)

The electroless copper plating bath of the present invention contains an amine compound in place of or in combination with the amine-based complexing agent described above.

This amine compound is a monoamine compound; examples of the monoamine compound include ammonia, monoethylamine, and dimethylamine.

Having fewer ligands than the amine-based complexing agent, the amine compound is required to be higher in concentration. Further, the amine-based complexing agent has a coordination number to copper of two or more and coordinates to copper so as to surround it and thus stably holds copper, whereas the amine compound has a coordination number of one and thus does not have such a function. From the foregoing, in one preferred embodiment, the concentration of the amine compound in the plating bath is 0.5 to 1.0 M.

The monoamine compound alone cannot achieve both bath stability and the likeliness of the occurrence of the plating reaction such as the amine-based complexing agent described above (see Comparative Example 7 described below) alike. However, when the aminocarboxylic acid-based complexing agent having a stability constant comparable to that of the amine-based complexing agent is used as an auxiliary ligand, deposition properties and bath stability can be improved (see Examples 7 and 8 described below).

### (Carboxylic Acid-Based Complexing Agent)

In the present invention, a carboxylic acid-based complexing agent is used in view of performing stable plating treatment. The carboxylic acid-based complexing agent is added to the electroless copper plating bath of the present invention in addition to the amine-based complexing agent and the aminocarboxylic acid-based complexing agent described above. Thus, a bath stability holding time is prolonged. Accordingly, bath stability can further be improved (see Examples 22 to 36 described below).

Examples of the carboxylic acid-based complexing agent include monocarboxylic acid, dicarboxylic acid, and oxycarboxylic acid (hydroxy acid). Examples of the monocarboxylic acid include formic acid, acetic acid, propionic acid, butyric acid, valeric acid, acrylic acid, trimethylacetic acid, benzoic acid, and chloroacetic acid. Examples of the dicarboxylic acid include malonic acid, succinic acid, malic acid, tartaric acid, oxalic acid, maleic acid, fumaric acid, citraconic acid, mesaconic acid, itaconic acid, aconitic acid, 2-pentene diacid, methylene succinic acid, allylmalonic acid, isopropylidene succinic acid, 2,4-hexadiene diacid, and acetylene dicarboxylic acid. Examples of the oxycarboxylic acid include citric acid, gluconic acid, lactic acid, glycol acid, ascorbic acid, diglycol acid, and salicylic acid.

The concentration of the carboxylic acid-based complexing agent in the plating bath is preferably 0.01 to 1.0 M and more preferably 0.01 to 0.2 M.

### (Temperature of Plating Bath)

The temperature of the plating bath, which is not limited to a particular temperature, is preferably 20 °C to 90 °C, more preferably 30 °C to 80 °C, and particularly preferably 40 °C to 60 °C. When the temperature of the plating bath is less than 20 °C, the deposition rate decreases to prolong a plating treatment time, which is unfavorable. When the bath temperature is higher than 90 °C, the deposition rate is extremely fast, thus forming a coarse film, and the thermal contraction of the film after plating may cause warping in the base, which is unfavorable. In addition, nodules and roughness are likely to occur, and film properties may degrade. Further, the plating bath becomes unstable, and the natural exhaustion of the reducing agent increases, leading to increase in cost.

### (Others)

The plating bath of the present invention may further contain various known additives added to electroless copper plating baths as needed. Examples of the additives include water-soluble copper salts, surfactants, and stabilizers.

More specifically, examples of water-soluble copper salts include copper sulfate, copper nitrate, copper chloride, copper acetate, copper citrate, copper tartrate, and copper gluconate. One or two or more of them mixed with any ratio may be contained in the electroless copper plating bath.

In addition, a surfactant and a nitrogen-containing aromatic compound as a stabilizer can be contained as needed to the extent that the plating deposition rate does not significantly decreases.

In the electroless copper plating bath of the present invention, the object to be plated is not limited to a particular type, and objects to be treated in conventional electroless copper plating may be employed as objects to be plated. In particular, the electroless copper plating bath of the present invention is effective in copper plated film formation in the object to be plated that is likely to cause deterioration due to strong alkalinity.

### <Electroless Copper Plating Treatment>

As the method of electroless copper plating using the electroless copper plating bath described above, a known method may be used. Specifically, sulfuric acid pickling treatment is performed on a base formed of copper or a copper alloy, and then electroless copper plating treatment is performed using the electroless copper plating bath described above, for example. The temperature during the electroless copper plating treatment is controlled to the bath temperature of the electroless copper plating bath described above.

The electroless copper plating treatment time is not limited to a particular time and may be set as appropriate so as to obtain a desired film thickness. Specifically, the electroless copper plating treatment time can be about 30 seconds to 15 hours, for example.

In performing the electroless copper plating treatment, with the progress of the plating treatment, copper ions are reduced to metallic copper by the reducing agent and to be deposited on the base. This lead to decrease in a copper ion concentration and a reducing agent concentration as well as change in the pH in the plating bath. Thus, in one preferred embodiment, the water-soluble copper salt as a copper ion source, the reducing agent, the complexing agent, and the other additives are supplied to the electroless copper plating bath continuously or regularly to maintain their concentrations at constant concentration ranges.

For recessed patterns such as vias and trenches, treatment with a cleaner or an organic solvent may be performed in view of improving liquid permeability. In addition, cleaner treatment may be performed in order to remove organic substances.

### EXAMPLES

The following describes the invention related to the present application more specifically based on examples and comparative examples. However, the present invention is not limited to the following examples at all.

### (Examples 1 to 36 wherein Examples 1-25 are out of the scope of the invention and Examples 26-36 are in the scope of the present invention, and Comparative Examples 1 to 7)

### (Preparation of Plating Bath)

Mixed were hydrazine monohydrate as the reducing agent, the amine-based complexing agent or the amine compound, the aminocarboxylic acid-based complexing agent, the carboxylic acid-based complexing agent, copper sulfate pentahydrate as the copper salt, polyethylene glycol as the surfactant, and 2,2'-dipyridyl as the nitrogen-containing aromatic compound so as to be the concentrations listed in Tables 1 to 3, and the mixture was stirred to prepare the plating baths of Examples 1 to 36 and Comparative Examples 1 to 7. The temperature of the plating baths was set to 50 °C, and the pH thereof was set to 5 to 10 (neutral).

### (Plating Treatment)

As listed in Tables 1 to 3, as the base as the object to be plated, a silicon wafer subjected to copper sputtering treatment (size: 20 mm x 20 mm, thickness: 2 mm) was prepared. Pickling as pretreatment was performed on this base at 25 °C for 1 minute.

Next, the base was immersed into each of the prepared plating baths for 15 minutes to form an electroless copper plated film having a thickness of 0.05 to 0.1 m on the object to be plated.

### (Plating Deposition Properties)

On the silicon wafer subjected to copper sputtering treatment, tone changes in the appearance of the silicon wafer by the deposition of copper was visually observed, and the deposition properties of the plated film formed by the plating treatment described above was evaluated. Specifically, the plated base was visually observed, and evaluation was performed based on whether or not any non-deposition exists (whether or not it is uniform deposition). Tables 1 to 3 list the foregoing results.

### (Stability of Plating Bath)

The plating baths after preparation were visually observed to evaluate whether or not copper deposition associated with bath decomposition exists. Specifically, it was visually observed and checked whether or not copper accumulation on the bottom of a plating tank exists or whether or not a copper film was formed on the plating tank. Tables 1 to 3 list the foregoing results.

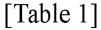

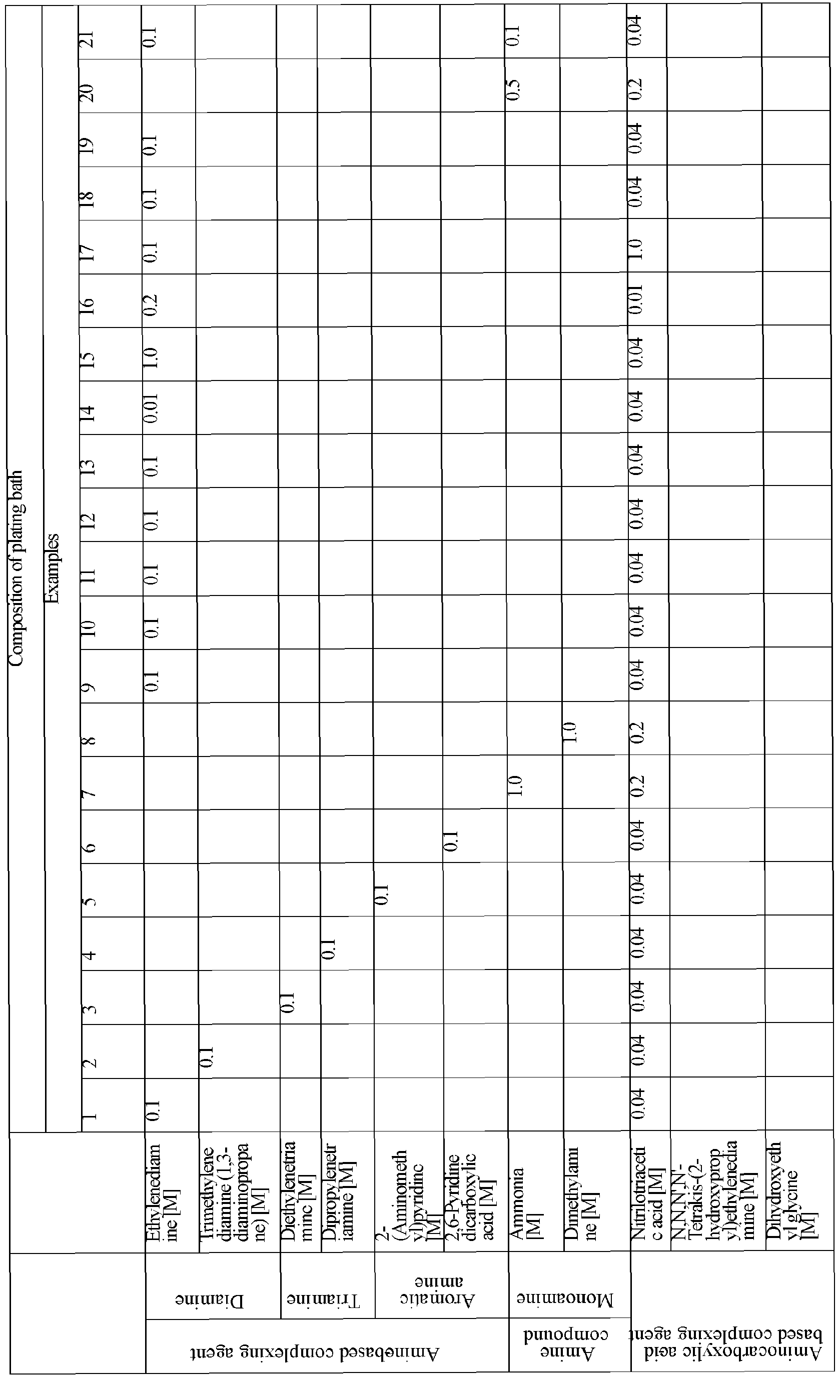

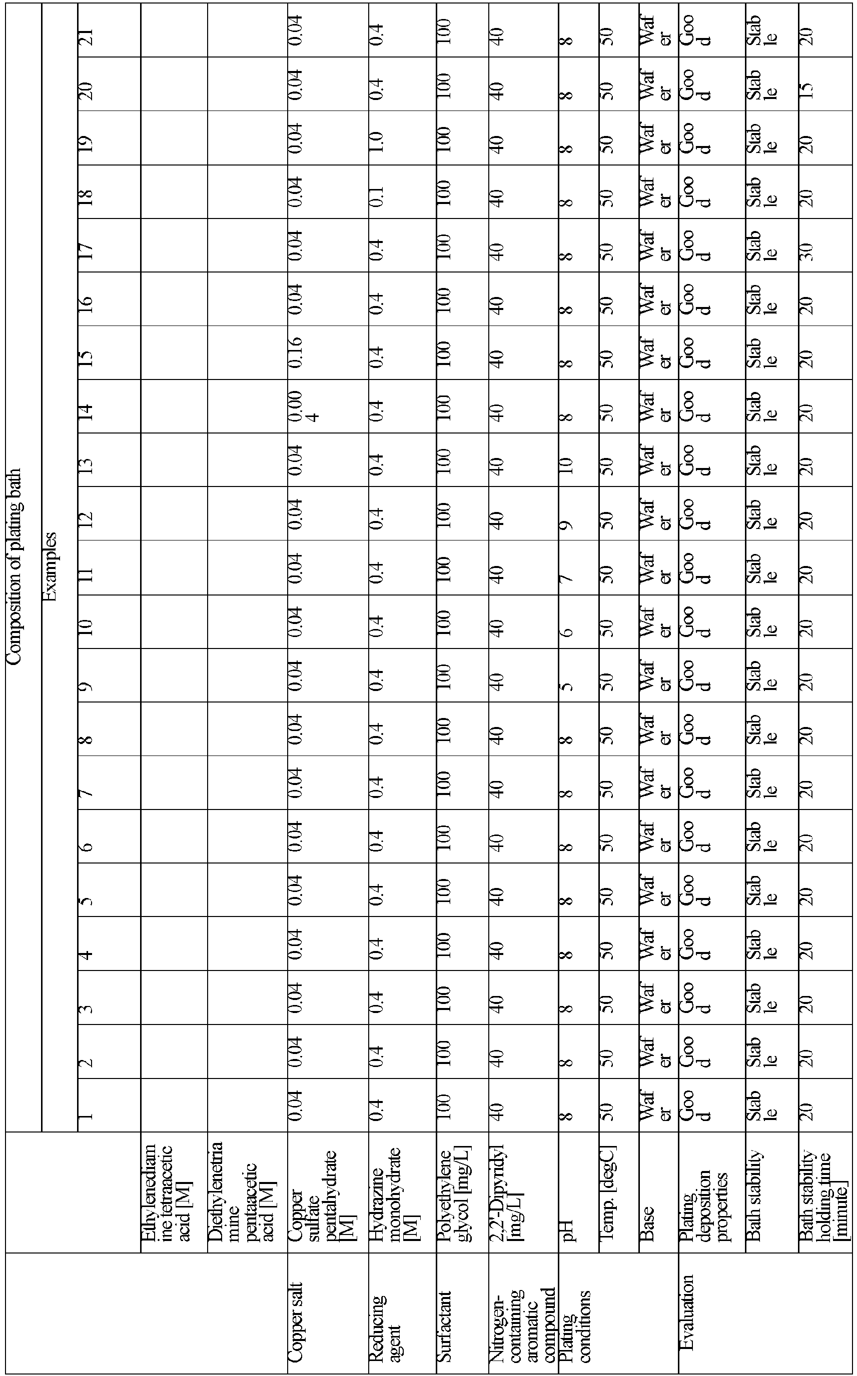

**[Table 2]**

| | | | Composition of dating bath | | | | | | | | | | | | | | |
|---|---|---|---|---|---|---|---|---|---|---|---|---|---|---|---|---|---|
| | | | Exampl es | | | | | | | | | | | | | | |
| | | | 22 | 23 | 24 | 25 | 26 | 27 | 28 | 29 | 30 | 31 | 32 | 33 | 34 | 35 | 36 |
| Amine-based complexing agent | Diamine | Ethylenediamine [M] | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 |
| | | Trimethylenedia mine (1,3-diaminopropane) [M] | | | | | | | | | | | | | | | |
| | Triamine | Diethylenetriamin e [M] | | | | | | | | | | | | | | | |
| | | Dipropylenetriam ine [M] | | | | | | | | | | | | | | | |
| | Aromatic amine | 2-(Aminomethyl)py ridine [M] | | | | | | | | | | | | | | | |
| | | 2,6-Pyridine dicarboxylic acid [M] | | | | | | | | | | | | | | | |
| Amine compound | Monoamine | Ammonia [M] | | | | | | | | | | | | | | | |
| | | Dimethylamine [M] | | | | | | | | | | | | | | | |
| Aminocarboxylic acid-based complexing agent | | Nitrilotriacetic acid [M] | | | | | 0.04 | 0.04 | 0.04 | 0.04 | 0.04 | 0.04 | 0.04 | 0.04 | 0.04 | 0.04 | 0.04 |
| | | N,N,N',N'-Tetrakis-(2-hydroxypropyl)et hylenediamine [M] | 0.04 | | | | | | | | | | | | | | |
| | | Dihydroxyethyl glycine [M] | | 0.04 | | | | | | | | | | | | | |
| | | Ethylenediamine tetraacetic acid [M] | | | 0.01 | | | | | | | | | | | | |
| | | Diethylenetriamin e pentaacetic acid [M] | | | | 0.01 | | | | | | | | | | | |
| Carboxylic acid-based complexing agent | Monocarbo xylic acid | Acetic acid [M] | | | | | 0.1 | | | | | | | | | 0.01 | 1.0 |
| | | Propionic acid [M] | | | | | | 0.1 | | | | | | | | | |
| | Dicarboxyli c acid | Succinic acid [M] | | | | | | | 0.01 | | | | | | | | |
| | | Maleic acid [M] | | | | | | | | 0.01 | | | | | | | |
| | | Itaconic acid [M] | | | | | | | | | 0.01 | | | | | | |
| | | Tartaric acid [M] | | | | | | | | | | 0.01 | | | | | |
| | Oxycarboxy lic acid (hydroxy acid) | Citric acid [M] | | | | | | | | | | | 0.01 | | | | |
| | | Lactic acid [M] | | | | | | | | | | | | 0.01 | | | |
| | | Ascorbic acid [M] | | | | | | | | | | | | | 0.01 | | |
| Copper salt | | Copper sulfate pentahydrate [M] | 0.04 | 0.04 | 0.04 | 0.04 | 0.04 | 0.04 | 0.04 | 0.04 | 0.04 | 0.04 | 0.04 | 0.04 | 0.04 | 0.04 | 0.04 |
| Reducing agent | | Hydrazine monohydrate [M] | 0.4 | 0.4 | 0.4 | 0.4 | 0.4 | 0.4 | 0.4 | 0.4 | 0.4 | 0.4 | 0.4 | 0.4 | 0.4 | 0.4 | 0.4 |
| Surfactant | | Polyethylene glycol [mg/L] | 100 | 100 | 100 | 100 | 100 | 100 | 100 | 100 | 100 | 100 | 100 | 100 | 100 | 100 | 100 |
| Nitrogen-containing aromatic compound | | 2,2'-Dipyridyl [mg/L] | 40 | 40 | 40 | 40 | 40 | 40 | 40 | 40 | 40 | 40 | 40 | 40 | 40 | 40 | 40 |
| Plating conditions | | pH | 8 | 8 | 8 | 8 | 8 | 8 | 8 | 8 | 8 | 8 | 8 | 8 | 8 | 8 | 8 |
| | | Temp. [degC] | 50 | 50 | 50 | 50 | 50 | 50 | 50 | 50 | 50 | 50 | 50 | 50 | 50 | 50 | 50 |
| | | Base | Wafer | Wafer | Wafer | Wafer | Wafer | Wafer | Wafer | Wafer | Wafer | Wafer | Wafer | Wafer | Wafer | Wafer | Wafer |
| Evaluation | | Plating deposition properties | Good | Good | Good | Good | Good | Good | Good | Good | Good | Good | Good | Good | Good | Good | Good |
| | | Bath stability | Stable | Stable | Stable | Stable | Stable | Stable | Stable | Stable | Stable | Stable | Stable | Stable | Stable | Stable | Stable |
| | | Bath stability holding time [minute] | 20 | 20 | 20 | 20 | 40 | 40 | 50 | 60 | 60 | 50 | 40 | 40 | 40 | 40 | 50 |

**[Table 3]**

| | | | Composition of plating bath | | | | | | |
|---|---|---|---|---|---|---|---|---|---|
| | | | Comparative Examples | | | | | | |
| | | | 1 | 2 | 3 | 4 | 5 | 6 | 7 |
| Amine-based complexing agent | Diamine | Ethylenediamine [M] | | | | | | | |
| | | Trimethylenediamine (1,3-diaminopropane) [M] | | | | | | | |
| | Triamine | Diethylenetriamine [M] | | | | | | | |
| | | Dipropylenetriamine [M] | | | | | | | |
| | Aromatic amine | 2-(Aminomethyl)pyridine | | | | | | | |
| | | 2,6-Pyridine dicarboxylic acid [M] | | | | | | | |
| Amine compound | Monoamine | Ammonia [M] | | | | | | | 1.0 |
| | | Dimethylamine [M] | | | | | | | |
| Aminocarbox ylic acid-based complexing agent | | Nitrilotriacetic acid [M] | | | 0.04 | | | 0.2 | |
| | | N,N,N',N'-Tetrakis-(2-hydroxypropyl)ethylenedi amine [M] | | | | | | | |
| | | Dihydroxyethyl glycine [M] | | | | | | | |
| | | Ethylenediamine tetraacetic acid [M] | 0.1 | | 0.1 | | | | |
| | | Diethylenetriamine pentaacetic acid [M] | | 0.1 | | | | | |
| Carboxylic acid-based complexing agent | Monocarboxylic acid | Acetic acid [M] | | | | | | | |
| | | Propionic acid [M] | | | | | | | |
| | Dicarboxylic acid | Succinic acid [M] | | | | | | | |
| | | Maleic acid [M] | | | | | | | |
| | | Itaconic acid [M] | | | | | | | |
| | | Tartaric acid [M] | | | | | 0.1 | | |
| | Oxycarboxylic acid (hydroxy acid) | Citric acid [M] | | | | 0.1 | | | |
| | | Lactic acid [M] | | | | | | | |
| | | Ascorbic acid [M] | | | | | | | |
| Copper salt | | Copper sulfate pentahydrate [M] | 0.04 | 0.04 | 0.04 | 0.04 | 0.04 | 0.04 | 0.04 |
| Reducing agent | | Hydrazine monohydrate [M] | 0.4 | 0.4 | 0.4 | 0.4 | 0.4 | 0.4 | 0.4 |
| Surfactant | | Polyethylene glycol [mg/L] | 100 | 100 | 100 | 100 | 100 | 100 | 100 |
| Nitrogen-containing aromatic compound | | 2,2'-Dipyridyl [mg/L] | 40 | 40 | 40 | 40 | 40 | 40 | 40 |
| Plating conditions | | pH | 8 | 8 | 8 | 8 | 8 | 8 | 8 |
| | | Temp. [degC] | 50 | 50 | 50 | 50 | 50 | 50 | 50 |
| | | Base | Wafer | Wafer | Wafer | Wafer | Wafer | Wafer | Wafer |
| Evaluation | | Plating deposition properties | Nondepositio n | Nondepositi on | Nondepositi on | - | - | - | - |
| | | Bath stability | Stable | Stable | Stable | Decompos ed | Decompos ed | Decompos ed | Decompos ed |
| | | Bath stability holding time [minute] | >120 | >120 | >120 | - | - | - | - |

As listed in Tables 1 and 2, it is shown that Examples 1 to 36, (examples 1 to 25 being out of scope of the present invention) which are each a neutral (pH 5 to 10) electroless copper plating bath containing the hydrazine compound as the reducing agent and not containing formaldehyde, the electroless copper plating bath containing the amine-based complexing agent or the amine compound and the aminocarboxylic acid-based complexing agent, have excellent deposition properties and bath stability and allow for deposition on copper without imparting any catalyst.

In particular, it is shown that Examples 26 to 36 in accordance with the invention, which each contain the carboxylic acid-based complexing agent, each have a prolonged bath stability holding time compared with those of Examples 1 to 25, making it possible to perform more stable plating treatment.

It is shown that Example 17, (out of scope of the present invention) which has a higher concentration of nitrilotriacetic acid as the complexing agent, has enhanced stability and a prolonged bath stability holding time.

Comparative Examples 1 to 3, in which the complexing powers of ethylene diamine tetraacetic acid and diethylene triamine pentaacetic acid are extremely strong, did not allow the plating reaction to proceed, depositing no copper. The plating reaction did not proceed, and the balance of the bath remained. Thus, the bath stability holding time was prolonged (as listed in Table 3, it was checked until 2 hours).

Comparative Examples 4 and 5, which each contain tartaric acid or citric acid alone as the complexing agent, caused turbidity of the bath the moment hydrazine monohydrate as the reducing agent was added dropwise and then bath decomposition.

As described above, nitrilotriacetic acid as the aminocarboxylic acid-based complexing agent has an auxiliary function for the amine-based complexing agent, and thus it is shown that Comparative Example 6, which contains nitrilotriacetic acid alone, cannot sufficiently exhibit bath stability.

It is considered that Comparative Example 7, which contains ammonia alone, caused bath decomposition because the amine-based complexing agent has a coordination number to copper of two or more and coordinates to copper so as to surround it and thus stably holds copper, whereas the amine compound has a coordination number of one and thus does not have such a function.

### INDUSTRIAL APPLICABILITY

The electroless copper plating bath of the present invention is suitably used in the neutral condition, which hardly causes degradation of the object to be plated in particular.

## Claims

1. An electroless copper plating bath with a pH of 5 to 10 containing hydrazine or a hydrazine compound as a reducing agent and not containing formaldehyde, the electroless copper plating bath comprising at least:
an amine-based complexing agent or an amine compound; and
an aminocarboxylic acid-based complexing agent,
wherein
the amine-based complexing agent is at least one selected from the group consisting of a diamine compound, a triamine compound, or an aromatic amine compound; the amine compound is a monoamine compound; and
the aminocarboxylic acid-based complexing agent is at least one selected from the group consisting of nitrilotriacetic acid, diethylene triamine pentaacetic acid, triethylenetetramine hexaacetic acid, 1,3-propanediamine tetraacetic acid, 1,3-diamino-2-hydroxypropane tetraacetic acid, hydroxyethylimino diacetic acid, dihydroxyethyl glycine, glycol ether diamino tetraacetic acid, dicarboxymethyl glutamic acid and ethylenediamine-N,N'-disuccinic acid,
and wherein said bath further comprises
a carboxylic acid-based complexing agent.

2. The electroless copper plating bath of claim 1, wherein
the carboxylic acid-based complexing agent is at least one selected from the group consisting of monocarboxylic acid, dicarboxylic acid, or oxycarboxylic acid.

## Patentansprüche

1. Bad zur stromlosen Verkupferung mit einem pH-Wert von 5 bis 10, das Hydrazin oder eine Hydrazinverbindung als ein Reduktionsmittel enthält und kein Formaldehyd enthält, wobei das Bad zur stromlosen Verkupferung mindestens umfasst:
ein Komplexierungsmittel auf Amin-Basis oder eine Aminverbindung; und
ein Komplexierungsmittel auf Aminocarbonsäure-Basis,
wobei
das Komplexierungsmittel auf Amin-Basis mindestens eines ist, das aus der Gruppe bestehend aus einer Diaminverbindung, einer Triaminverbindung oder einer aromatischen Aminverbindung ausgewählt ist; die Aminverbindung eine Monoaminverbindung ist; und
das Komplexierungsmittel auf Aminocarbonsäure-Basis mindestens eines ist, das aus der Gruppe bestehend aus Nitrilotriessigsäure, Diethylentriaminpentaessigsäure, Triethylentetraminhexaessigsäure, 1,3-Propandiamintetraessigsäure, 1,3-Diamino-2-hydroxypropantetraessigsäure, Hydroxyethyliminodiessigsäure, Dihydroxyethylglycin, Glykoletherdiaminotetraessigsäure, Dicarboxymethylglutaminsäure und Ethylendiamin-N,N'-dibernsteinsäure ausgewählt ist,
und wobei das Bad weiterhin umfasst:
ein Komplexierungsmittel auf Carbonsäure-Basis.

2. Bad zur stromlosen Verkupferung nach Anspruch 1, wobei
das Komplexierungsmittel auf Carbonsäure-Basis mindestens eines ist, das aus der Gruppe bestehend aus Monocarbonsäure, Dicarbonsäure oder Oxycarbonsäure ausgewählt ist.

## Revendications

1. Bain de cuivrage chimique autocatalytique avec un pH allant de 5 à 10 contenant de l'hydrazine ou un composé hydrazine comme agent réducteur et ne contenant pas de formaldéhyde, le bain de cuivrage chimique autocatalytique comprenant au moins :
un agent complexant à base d'amine ou un composé amine ; et
un agent complexant à base d'acide aminocarboxylique,
dans lequel
l'agent complexant à base d'amine est au moins un agent choisi dans le groupe constitué par un composé diamine, un composé triamine ou un composé amine aromatique ; le composé amine est un composé monoamine ; et
l'agent complexant à base d'acide aminocarboxylique est au moins un agent choisi dans le groupe constitué par l'acide nitrilotriacétique, l'acide diéthylène triamine pentaacétique, l'acide triéthylènetétramine hexaacétique, l'acide 1,3-propanediamine tétraacétique, l'acide 1,3-diamino-2-hydroxypropane tétraacétique, l'acide hydroxyéthyliminodiacétique, la dihydroxyéthylglycine, l'acide glycol éther diamine tétraacétique, l'acide dicarboxyméthylglutamique et l'acide éthylènediamine-N,N'-disuccinique,
et dans lequel ledit bain comprend en outre
un agent complexant à base d'acide carboxylique.

2. Bain de cuivrage chimique autocatalytique de la revendication 1, dans lequel
l'agent complexant à base d'acide carboxylique est au moins un agent choisi dans le groupe constitué par un acide monocarboxylique, un acide dicarboxylique ou un acide oxycarboxylique.
